# EUROPEAN PATENT APPLICATION

(11) **EP 3 745 448 A1**
(43) Date of publication of application: **02.12.2020**
(21) Application number: 19744037.3
(22) Date of filing: 22.01.2019
(51) Int. Cl.: H01L 21/52, B23K 35/14, B23K 35/26, B23K 35/30, C22C 9/02, C22C 13/00, H01L 23/36

(54) **JOINING LAYER OF SEMICONDUCTOR MODULE, SEMICONDUCTOR MODULE, AND METHOD FOR MANUFACTURING SAME**

(30) Priority: 24.01.2018 JP 2018009471
(71) Applicant: Mitsubishi Materials Corporation, Tokyo 100-8117 (JP)
(72) Inventor: IWATA, Koutaro, Naka-shi, Ibaraki 311-0102 (JP); HIGAMI, Akihiro, Naka-shi, Ibaraki 311-0102 (JP); MURAOKA, Hiroki, Naka-shi, Ibaraki 311-0102 (JP); YAMAGUCHI, Tomohiko, Naka-shi, Ibaraki 311-0102 (JP)
(74) Representative: Gille Hrabal
(86) International application number: PCT/JP2019/001827
(87) International publication number: WO 2019/146587

(57) **Abstract**

Provided is a joining layer (13) of a semiconductor module (10) that is provided between an electronic component (14) and a substrate (15), and consists of a CuSn intermetallic compound. This joining layer (13) is configured such that the composition ratio of Sn increases from a central part (13a) thereof to joining parts (13b and 13c) at ends (14a and 14b) of the electronic component (14). The semiconductor module (10) is produced by placing a paste containing a Cu-core/Sn-shell-powder between the electronic component (14) and the substrate (15) and heating the electronic component (14) and/or the substrate (15) at a temperature of 250°C to 350°C for 1 to 10 minutes under a pressure of 1 MPa to 30 MPa in an inert or reducing atmosphere while the paste is kept to join the electronic component (14) to the substrate (15).

## Description

### TECHNICAL FIELD

The present invention relates to a joining layer of a semiconductor module that is provided between a substrate and an electronic component such as a semiconductor chip element or a LED chip element. The present invention further relates to a semiconductor module using the joining layer and a method for manufacturing the same. This international application claims priority to Japanese Patent Application No. 2018-009471 filed on January 24, 2018, the content of which is incorporated herein in its entirety.

### BACKGROUND ART

In recent years, attention has been paid to a wide-bandgap semiconductor that acts even at a temperature of higher than 200°C, such as SiC. As a method for joining a semiconductor chip element that acts at high temperature, attention has been paid to a joining method that is referred to as a transient liquid phase sintering method (TLP method) in which a joining material containing Cu and Sn is heated at a temperature higher than the melting point of Sn with the joining material interposed between a semiconductor chip element and a substrate, to form an inter-metallic compound (IMC) having a composition of Cu₆Sn₅ or Cu₃Sn. A method for manufacturing a semiconductor module using a connection layer or a binder that is formed by this joining method is disclosed (e.g., see Patent Documents 1 and 2).

In a method for manufacturing a semiconductor module in Patent Document 1, two Cu-containing soldering base materials and a Sn-containing solder layer disposed between the two Cu-containing soldering base materials are pressed against one another with a predetermined pressure to melt the solders, and after a predetermined time period, Cu and Sn which diffuse from the liquid solders form a connection layer containing an intermetallic compound CuSn phase . Namely, in this manufacturing method, a joining layer in which joining base materials having a Cu-metalized surface are disposed between Sn-containing solder layers is formed. According to the manufacturing method, resistance to frequent temperature change with variation of high temperature that is caused during action of a power semiconductor module (hereinafter referred to as resistance to high temperature) may be improved.

A method for manufacturing a semiconductor module in Patent Document 2 includes steps of applying a binder containing Cu particles and Sn particles to a joining surface of a semiconductor chip element or a substrate, bonding the joining surface of the semiconductor chip element and the joining surface of the substrate through the binder, heating the binder at a temperature higher than the melting point of Sn, resulting in transient liquid phase sintering of Cu and Sn in the binder, to change the composition of the binder to a composition containing Cu₆Sn₅ and Cu₃Sn, and further heating the binder to change Cu₆Sn₅ of the binder to Cu₃Sn and increase the ratio of Cu₃Sn in the binder. Namely, in this manufacturing method, a Cu powder is mixed with a Sn powder, a solvent and a flux are added to this mixture to obtain a paste, and this paste is printed on an electrode of the semiconductor chip element and an electrode of the substrate. According to the manufacturing method, when a method using a conventional solder for joining a semiconductor chip element that acts at high temperature is adopted, the performance of the semiconductor chip element is deteriorated during remelting of the solder, formation of an intermetallic compound (IMC) on an interface, or the like. However, the manufacturing method can solve the deterioration.

### PRIOR PART DOCUMENTS

### PATENT LITERATURE

Patent Document 1: Japanese Patent Application Laid-Open No. 2012-74726 (Abstract)
Patent Document 2: Japanese Patent Application Laid-Open No. 2014-199852 (Claim 1, and Paragraphs [0005] and [0006])

### SUMMARY OF INVENTION

### PROBLEMS TO BE SOLVED BY THE INVENTION

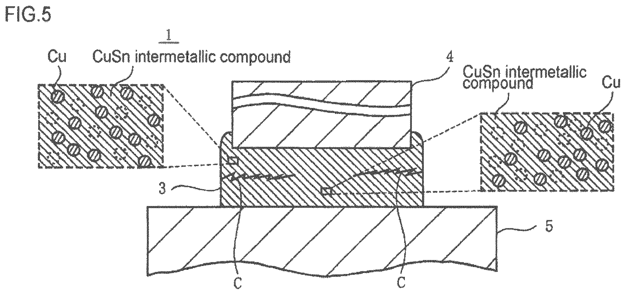

Both the connection layer described in Patent Document 1 and the binder described in Patent Document 2 (hereinafter referred to as a joining layer) have a composition that is formed from a phase of an intermetallic compound Cu₆Sn₅ or Cu₃Sn uniformly from one end to the other end of the joining surface of the semiconductor chip element mounted on the substrate. Although such a CuSn intermetallic compound layer has high strength, the CuSn intermetallic compound layer is formed from a brittle material. Therefore, in a semiconductor chip element 4 and a substrate 5 that are joined through a joining layer 3 formed from the CuSn intermetallic compound layer in a semiconductor module 1, as illustrated in FIG. 5, a stress to the joining layer that is caused by a difference in thermal expansion between the semiconductor chip element and the substrate cannot sufficiently be relaxed when the semiconductor chip element and/or the substrate are subjected to repetitive heating and cooling during repetitive on-off control action of the semiconductor module. As a result, a crack C is caused in a horizontal direction from an end of the joining layer 3. This crack C may be a heat resistance factor when a heat generated from the semiconductor chip element 4 is released to the substrate 5. The crack C is sometimes developed, resulting in detachment of the semiconductor chip element 4, that is, a damage of an electronic component.

An object of the present invention is to solve the aforementioned problem, and to provide a joining layer of a semiconductor module the joining layer that has excellent adherence to an electronic component and a substrate in joining and high joining strength, is not remelted even if it has been exposed to a high-temperature atmosphere after joining, and does not cause a damage of the electronic component due to a crack caused by repetitive heating and cooling of the electronic component and/or the substrate. Another object of the present invention is to provide a semiconductor module that does not cause a damage of an electronic component during repetition of on-off control action of the semiconductor module and a method for manufacturing the semiconductor module.

### MEANS TO SOLVE PROBLEMS

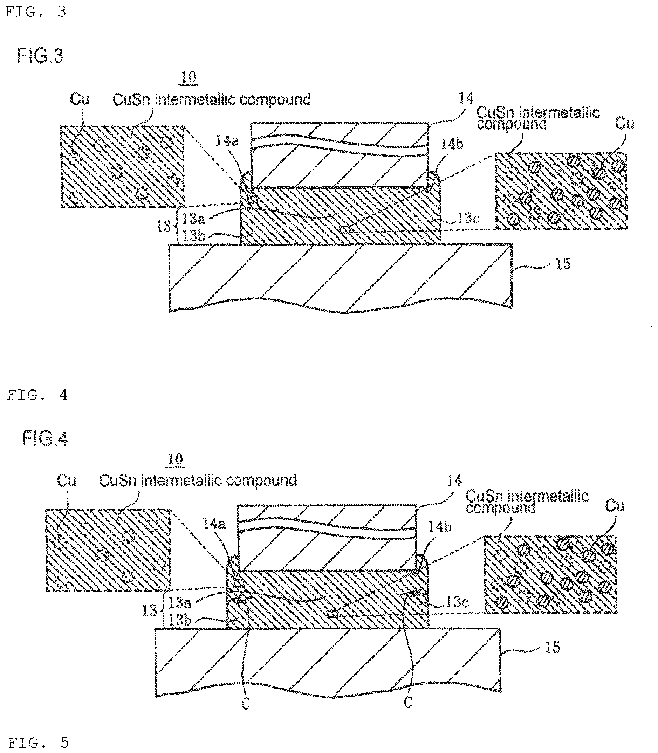

A first aspect of the present invention is a joining layer 13 of a semiconductor module 10 that is provided between an electronic component 14 and a substrate 15, as illustrated in FIG. 3, and is configured of a CuSn intermetallic compound, wherein the composition ratio of Sn increases from a central part 13a of the joining layer 13 to joining parts 13b and 13c at ends 14a and 14b of the electronic component 14.

A second aspect of the present invention is the joining layer 13 of the semiconductor module 10 according to the first aspect, wherein the composition ratio of Sn at the central part 13a of the joining layer 13 is 20% by mass to 50% by mass and the composition ratio of Cu is the balance, and the composition ratio of Sn in the joining parts 13b and 13c at the ends 14a and 14b of the electronic component 14 is 60% by mass to 80% by mass and the composition ratio of Cu is the balance.

A third aspect of the present invention is the invention according to the first or second aspect, wherein the joining layer 13 has a thickness of 10 µm to 200 µm.

A fourth aspect of the present invention is a semiconductor module 10 including the joining layer 13 according to any one of the first to third aspects that is provided between the electronic component 14 and the substrate 15.

A fifth aspect of the present invention is a method for manufacturing the semiconductor module 10 including placing a paste 12 containing a Cu-core/Sn-shell-powder 11 between an electronic component and a substrate and heating the electronic component 14 and/or the substrate 15 at a temperature of 250°C to 350°C for 1 minute to 10 minutes under a pressure of 1 MPa to 30 MPa in an inert atmosphere or a reducing atmosphere while the paste 12a is kept, to join the electronic component 14 to the substrate 15.

A sixth aspect of the present invention is the method for manufacturing the semiconductor module 10 according to the fifth aspect, wherein the composition ratio of Sn in the Cu-core/Sn-shell-powder 11 is 40% by mass to 60% by mass and the composition ratio of Cu is the balance.

### EFFECTS OF INVENTION

As illustrated in FIG. 3, the joining layer 13 according to the first aspect of the present invention is configured such that the composition ratio of Sn increases from the central part 13a thereof to the joining parts 13b and 13c at the ends 14a and 14b of the electronic component 14 (see an enlarged view of FIG. 3) . Therefore, the central part 13a consists of a CuSN intermetallic compound having high Cu composition, and the joining parts 13b and 13c consist of a CuSn intermetallic compound having high Sn composition. Accordingly, the joining layer 13 at the central part 13a has high resistance to high temperature and excellent heat dissipation. Further, the brittleness of the joining parts 13b and 13c is lower than that of a conventional joining part. Even when the electronic component 14 and/or the substrate 15 are subjected to repetitive heating and cooling during repetitive on-off control action of the semiconductor module 10, to cause thermal shock to the joining layer 13, the ends 14a and 14b of the electronic component 14 to which comparatively high stress is applied during manufacture are expanded or contracted. As illustrated in FIG. 4, even when a crack C is caused in a horizontal direction from the ends 13b and 13c of the joining part 13 due to a difference in thermal expansion between the electronic component 14 and the substrate 15, a stress to the joining parts 13b and 13c can be relaxed, and the crack C is unlikely to be developed. Therefore, a heat generated from the semiconductor chip element 14 can smoothly be released to the substrate 15, to prevent a damage of the electronic component.

In the joining layer 13 according to the second aspect of the present invention, as illustrated in the enlarged view of FIG. 3, the composition ratio of Sn at the central part 13a of the joining layer 13 is 20% by mass to 50% by mass and the composition ratio of Cu is the balance, and the composition ratio of Sn in the joining parts 13b and 13c at the ends 14a and 14b of the electronic component 14 is 60% by mass to 80% by mass and the composition ratio of Cu is the balance. Therefore, the joining layer 13 has high adherence to the electronic component and the substrate, high joining strength, and resistance to high temperature, and the brittleness of the joining layer 13 at the joining parts 13a and 13b is certainly decreased. Even when a crack C is caused in a horizontal direction from the ends 13b and 13c of the joining part 13 by thermal shock to the joining layer 13, as illustrated in FIG. 4, a stress to the joining parts 13b and 13c can be relaxed, and the crack C is unlikely to be developed.

The joining layer 13 according to the third aspect of the present invention has a thickness of 10 µm to 200 µm, and therefore the joining layer 13 has high joining strength. In addition to characteristics such as not remelting, resistance to thermal shock is enhanced.

In the semiconductor module 10 according to the fourth aspect of the present invention, the joining layer 13 formed from a CuSn intermetallic compound has characteristics according to the first to third aspects. Even when a crack C is caused in a horizontal direction from the ends 13b and 13c of the joining part 13 by repetitive on-off control action of the semiconductor module 10, a stress to the joining parts 13b and 13c can be relaxed, and the crack C is unlikely to be further developed. Therefore, a heat generated from the semiconductor chip element 14 can smoothly be released to the substrate 15 to prevent a damage of the electronic component.

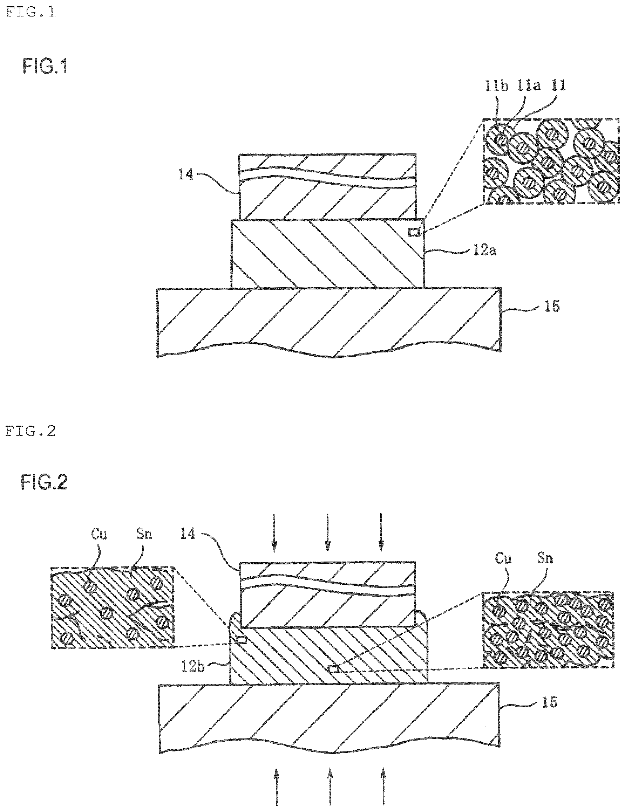

In the method for manufacturing the semiconductor module 10 according to the fifth aspect of the present invention, the paste 12a containing the Cu-core/Sn-shell-powder 11 is provided between the electronic component 14 and the substrate 15 as illustrated in FIG. 1, and the electronic component 14 and/or the substrate 15 are heated at 250°C to 350°C for 1 minute to 10 minutes under a pressure of 1 MPa to 30 MPa in an inert atmosphere or a reducing atmosphere with the paste kept as illustrated in FIG. 2. As a result, Sn that forms a shell under heating and has a melting point of 232°C is melted, a shell structure collapses, and adjacent Sn powders are integrated to form a liquid, as illustrated in enlarged views of FIGs. 1 and 2. In contrast, Cu that forms a core of the Cu-core/Sn-shell-powder 11 in the paste and has a melting point of 1085°C is not melted, and starts to form a CuSn intermetallic compound with the liquid Sn under a partial diffusion reaction. The liquid Sn shifts from a central part of a lower surface of the electronic component 14 to the ends 14a and 14b by application of pressure, and at the central part of the lower surface of the electronic component 14, Cu that is not melted (is shown as a circle with a solid line in the drawings, and the same applies hereinafter) and the slightly formed CuSn intermetallic compound are held in a state before heating under pressure. Thus, a joining layer precursor 12b is obtained. After molding by heating under pressure for a predetermined time, the joining layer precursor 12b between the electronic component 14 and the substrate 15 is cooled under pressure. As illustrated in FIG. 3, the joining layer 13 of which the central part is formed from Cu and the CuSn intermetallic compound, and both ends are formed from Sn and the CuSn intermetallic compound is formed (in the drawing, the melted Cu is shown with a dashed line) . As a result, the electronic component 14 is joined to the substrate 15 through the joining layer 13, and the joining layer 13 includes the CuSn intermetallic compound in which the composition ratio of Sn increases from the central part 13a of the joining layer 13 to the joining parts 13b and 13c at the ends 14a and 14b of the electronic component 14 (see, the enlarged view of FIG. 3).

In the sixth aspect of the present invention, the composition ratio of Sn in the Cu-core/Sn-shell-powder 11 is a predetermined ratio. Therefore, it is easy that the composition ratio of Sn at the central part 13a of the joining layer 13 is set to 20% by mass to 50% by mass and the composition ratio of Sn at the joining parts 13b and 13c is set to 60% by mass to 80% by mass.

### BRIER DESCRIPTION OF DRAWINGS

FIG. 1 is a view in which a paste containing a Cu-core/Sn-shell-powder is provided between an electronic component and a substrate in a process for manufacturing a semiconductor module of an embodiment.
FIG. 2 is a view in which the electronic component and/or the substrate is molded by heating under pressure in the process for manufacturing a semiconductor module of the embodiment.
FIG. 3 is a view of a state where the electronic component is joined to the substrate after molding the electronic component and/or the substrate by heating under pressure in the process for manufacturing a semiconductor module of the embodiment.
FIG. 4 is a schematic view when a crack is caused in a joining layer of a semiconductor module of the embodiment.
FIG. 5 is a schematic view when a crack is caused in a joining layer of a conventional semiconductor module.

### EMBODIMENTS FOR PERFORMING THE INVENTION

Hereinafter, embodiments for performing the present invention will be described on the basis of the drawings.

### <Method for Manufacturing Semiconductor Module> <Cu-core/Sn-shell-powder>

As illustrated in the enlarged view of FIG. 1, a Cu-core/Sn-shell-powder 11 of an embodiment has a core (centronuclear) 11a consisting of Cu or an intermetallic compound part of Cu and Sn, and a shell (outer shell) 11b consisting of Sn. Therefore, under heating at a temperature of 250°C to 350°C, Sn of the shell is melted, but Cu of the core is not melted.

It is preferable that the Cu-core/Sn-shell-powder has an average particle diameter of 1 µm to 10 µm. When the average particle diameter is less than 1 µm, the powder is likely to be aggregated, and a paste is unlikely to be formed. Further, the thickness of the Sn shell is decreased, and therefore there are inconveniences that a Sn liquid phase is insufficient due to diffusion of Cu/Sn during joining, and a joining structure is loose. When the average particle diameter is more than 10 µm, the thickness of the Sn shell is increased. Therefore, it takes a long time to produce a CuSn intermetallic compound due to diffusion of Cu/Sn during joining. Further, a space between the powders is not sufficiently filled, and the joining structure is loose . This average particle diameter is a volume cumulative median diameter (Median diameter, D₅₀) that is measured by a particle size distribution measuring device using a laser diffraction and scattering method (manufactured by Horiba, Ltd., laser diffraction and scattering-type particle size distribution measuring device LA-950) .

It is preferable that the composition ratio of Sn in the Cu-core/Sn-shell-powder be 40% by mass to 60% by mass, and the composition ratio of Cu be the balance. It is further preferable that the composition ratio of Sn be 45% by mass to 55% by mass. When the composition ratio of Sn is less than 40% by mass, the adherence and joining properties to an electronic component and a substrate described below are not sufficiently enhanced, the amount of Sn melted during molding by heating the electronic component and/or the substrate under pressure is low, and the composition ratio of Sn in a joining layer at ends of the electronic component is unlikely to be increased. When the composition ratio of Sn is more than 60% by mass, the amount of Sn remained after molding by heating under pressure is increased, and heat resistance is deteriorated.

A method for manufacturing the Cu-core/Sn-shell-powder of the embodiment will be described. A Cu-containing compound such as copper (II) chloride, copper (II) sulfate, or copper acetate, or a Cu powder, a Sn-containing compound such as tin (II) chloride, tin (II) sulfate, tin (II) acetate, or tin (II) oxalate, and a dispersant are first added and mixed to prepare a solution. The ratios of the Sn-containing compound and the Cu-containing compound in the solution are adjusted so that the composition ratios of Sn and Cu after manufacturing the Cu-core/Sn-shell-powder fall within the aforementioned ranges.

Examples of a solvent include water, alcohols, ethers, ketones, and esters. Examples of the dispersant include cellulose-based, vinyl-based, and polyhydroxy alcohol-based dispersants. Further, gelatin, casein, or the like may be used. The pH of the prepared solution is adjusted within a range of 0 to 2.0. In consideration of redissolution of solder powder to be produced, it is preferable that the pH be adjusted within a range of 0 to 2.0.

Subsequently, an aqueous solution of a reductant is prepared, and the pH of this aqueous solution is adjusted to a pH similar to that of the prepared solution. Examples of the reductant include borohydrides such as sodium tetrahydroborate and dimethylamine borane, nitrogen compounds such as hydrazine, and metal ions such as trivalent titanium ions and divalent chromium ions.

Next, the reductant aqueous solution is added and mixed in the solution to reduce Sn ions and Cu ions in the solution. As a result, a dispersion liquid in which the Sn powder and the Cu powder are dispersed in the liquid is obtained. In this reduction reaction, if the solution in which the Cu-containing compound and the Sn-containing compound are dissolved is used, Cu that is nobler than Sn is first reduced, and Sn is finally reduced. As a result, a precursor of a Cu-core/Sn-shell-powder configured of a core (centronuclear) of Cu and a shell (outer shell) of Sn that coats the core is formed.

Subsequently, this dispersion liquid is subjected to solid-liquid separation by decantation or the like, and a collected solid content is washed with water or an aqueous hydrochloric acid solution, an aqueous nitric acid solution, or an aqueous sulfuric acid solution having an adjusted pH of 0.5 to 2, or methanol, ethanol, or acetone. After washing, solid-liquid separation is carried out again, and a solid content is collected. A process from washing to solid-liquid separation is repeated preferably two to five times. As a result, the Cu-core/Sn-shell-powder is obtained.

### <Paste>

The obtained Cu-core/Sn-shell-powder is mixed with a flux for joining at a predetermined ratio to obtain a paste. The flux for joining used in preparation of the paste is not particularly limited. A flux prepared by mixing various components such as a solvent, a rosin, a thixotropic agent, and an activator that are publicly known and widely used can be used. The paste of the embodiment does not include a paste prepared by mixing a Cu powder and a Sn powder as described in Patent Document 2 with the flux.

### <Presence of Paste between Electronic Component and Substrate>

Subsequently, the obtained paste 12a is provided between the electronic component 14 such as a semiconductor chip element and a LED chip element of the embodiment and the substrate 15, as illustrated in FIG. 1. For example, a metal mask having an opening at a part on which an electronic component is mounted is layered on a substrate horizontally placed, and a paste is put on the metal mask, and drained to the opening of the metal mask using a squeegee. While the metal mask is kept, the substrate is brought down. As a result, the paste is left on the substrate at a position corresponding to the opening. Next, the electronic component is placed on this paste. Thus, the paste is provided between the electronic component and the substrate. When the thickness of the metal mask is set to 20 µm to 300 µm, the thickness of a joining layer described below can be 10 µm to 200 µm.

### <Molding by Heating under Pressure>

While the electronic component 14 is placed on the paste 12a, that is, while the paste 12a is provided between the electronic component 14 and the substrate 15, the paste 12a is molded by heating under pressure using a lower press and an upper press that are not shown in an inert atmosphere or a reducing atmosphere, as illustrated in FIG. 2. A condition of molding by heating under pressure includes application of a pressure of 1 MPa to 30 MPa to the electronic component and/or the substrate and heating at a temperature of 250°C to 350°C for 1 minute to 100 minutes. By this heating, Sn of the shell 11b of the Cu-core/Sn-shell-powder 11 in the paste is melted, a shell structure collapses, and adjacent Sn powders are integrated into a liquid, as illustrated in the enlarged view of FIG. 2. By application of this pressure, the liquid Sn shifts from a central part of a lower surface of the electronic component 14 to the ends 14a and 14b, Cu that is not melted is held at the central part of the lower surface of the electronic component 14 in a state before heating under pressure, and the joining layer precursor 12b is obtained.

This molding by heating under pressure is for prevention of oxidation of the obtained joining layer. The molding by heating under pressure is carried out in an inert atmosphere of vacuum gas, nitrogen gas, argon gas, or a mixed gas of nitrogen with argon or a reducing atmosphere of a mixed gas of nitrogen with hydrogen or a formic acid gas. When the pressure is less than 1 MPa, a force of pushing Sn liquefied by application of pressure to the joining parts 13b and 13c at the ends 14a and 14b of the electronic component 14 is not sufficient, and Sn composition at the joining parts 13b and 14b is not increased. When the pressure is more than 30 MPa, the electronic component is damaged. The pressure is preferably 2 MPa to 20 MPa, and more preferably 5 MPa to 15 MPa. When a predetermined pressure is applied, the thickness of the joining layer described below together with the thickness of the paste can be 10 µm to 200 µm.

When the temperature during molding by heating under pressure is lower than 250°C, Sn of the shell of the Cu-core/Sn-shell-powder is not sufficiently melted, and the adherence and joining properties to the electronic component and the substrate are deteriorated. When the temperature is higher than 350°C, the distortion due to a thermal stress of the joining layer precursor 12b when the joining layer precursor 12b is cooled is increased, and additionally, the thermal load against a semiconductor module is increased. The temperature is preferably 280°C to 320°C.

When the time during molding by heating under pressure is less than 1 minute, production of a CuSn intermetallic compound due to inter-diffusion of Sn and/or Cu of the Cu-core/Sn-shell-powder is insufficient, and resistance of the joining layer at a high temperature is deteriorated. The reason why the upper limit value of heating time is 10 minutes is that production of the CuSn intermetallic compound is approximately completed in 10 minutes. Heating for more than 10 minutes leads to waste of an energy and a decrease in productivity. The time is preferably 3 minutes to 5 minutes.

### <Semiconductor Module>

If the joining layer precursor is cooled under pressure after molding by heating under pressure for a predetermined time, a semiconductor module 30 in which the electronic component 14 is joined to the substrate 15 through the joining layer 13 consisting of the CuSn intermetallic compound, as illustrated in FIG. 3, is obtained. Namely, after cooling, the joining layer precursor 12b between the electronic component 14 and the substrate 15 is wholly changed to the joining layer 13 consisting of the CuSn intermetallic compound. As a result, the electronic component 14 is joined to the substrate 15 through the joining layer 13, and the joining layer 13 becomes the CuSn intermetallic compound in which the composition ratio of Sn increases from the central part 13a of the joining layer 13 to the joining parts 13b and 13c at the ends 14a and 14b of the electronic component 14.

The joining layer 13 is configured of an CuSn intermetallic compound such as an intermetallic compound having a high melting point Cu₃Sn (solidification initiating temperature: 676°C) or Cu₆Sn₅ (solidification initiating temperature: 415°C). Therefore, the joining strength to the electronic component 14 and the substrate 15 is high, the joining layer 13 is not remelted even when exposed to a high-temperature atmosphere after joining, and the joining layer 13 has excellent resistance at a high temperature.

It is preferable that the joining layer 13 be a joining layer 13 of a semiconductor module 10 in which the composition ratio of Sn at the central part 13a is 20% by mass to 50% by mass, and preferably 30% by mass to 40% by mass, the composition ratio of Cu is the balance, the composition ratio of Sn in the joining parts 13b and 13c at the ends 14a and 14b of the electronic component 14 is 60% by mass to 80% by mass, and preferably 60% by mass to 70% by mass, and the composition ratio of Cu is the balance.

When the composition ratio of Sn at the central part 13a of the joining layer 13 is less than 20% by mass, the adherence and joining properties of the central part 13a of the joining layer 13 to the electronic component 14 and the substrate 15 are likely to be decreased. When it is more than 50% by mass, the ratio of Cu₆Sn₅ that has poor thermal conductivity is increased, heat dissipation is likely to be deteriorated.

When the composition ratio of Sn in the joining parts 13b and 13c at the ends 14a and 14b of the electronic component 14 is less than 60% by mass, a decrease in brittleness of the joining layer 13 at the joining parts 13b and 13c is not found, and stress relaxation is unlikely to be expressed during thermal shock to the joining parts 13b and 13c. When it is more than 80% by mass, a large amount of Sn phase is left even after joining, and resistance to high temperature is likely to be deteriorated.

The thickness of the joining layer 13 is 10 µm to 200 µm, and preferably 20 µm to 100 µm. As described above, this thickness is adjusted by the thickness of the paste 11 illustrated in FIG. 1 and the pressure applied during molding by heating under pressure. When the thickness is less than 10 µm, the adherence and joining properties of the joining layer 13 to the electronic component 14 and the substrate 15 are likely to be decreased. When it is more than 200 µm, the heat resistance of the joining layer 13 is increased, and heat dissipation of the joining layer is likely to be decreased.

In the semiconductor module 10 of the embodiment, the joining layer 13 consists of a CuSn intermetallic compound having high solidification initiating temperature, which is typified by Cu₆Sn₅ having a solidification initiating temperature of 415°C and/or Cu₃Sn having a solidification initiating temperature of 676°C. Therefore, the heat resistance of the joining layer 13 is largely improved, and remelting and a decrease in joining strength can be prevented. In particular, the joining layer 13 is suitable for mounting on a substrate of an electronic component that is exposed to a high-temperature atmosphere. The composition ratio of Sn at the ends 13b and 13c of the joining layer 13 is high. Therefore, a stress is relaxed by expansion and contraction when the electronic component 14 and/or the substrate 15 are subjected to repetitive heating and cooling. In addition, even when a crack C is caused in a horizontal direction from the ends 13b and 13c of the joining part 13 due to a difference in thermal expansion between the electronic component 14 and the substrate 15, as illustrated in FIG. 4, a stress to the ends 13b and 13c can be relaxed, and the crack C is unlikely to be developed. As a result, a heat generated from the semiconductor chip element 14 can be smoothly released to the substrate 15 to prevent a damage of the electronic component.

Hereinafter, Examples of the present invention will be described in detail with Comparative Examples.

### <Example 1>

A Cu-core/Sn-shell-powder (Cu: 50% by mass, Sn: 50% by mass) having an average particle diameter of 5 µm was mixed with a middle active flux (RMA flux) containing a middle activator at a ratio of the flux of 13% by mass to prepare a paste. The obtained paste was applied to a 20-mm square Kovar (Fe-Ni-Co-based alloy) substrate of 0.5 mm in thickness so that the thickness of the paste was 50 µm. On this paste, a 2.5-mm square semiconductor chip element having a rear face sputtered with Au was then mounted. Subsequently, the Kovar substrate having the semiconductor chip element was put in a pressurizing and heating furnace, and the semiconductor chip element and the Kovar substrate were held at a temperature of 300°C for 5 minutes with a pressure of 10 MPa applied to the semiconductor chip element and the Kovar substrate in a nitrogen atmosphere. Thus, molding by heating under pressure was carried out. As a result, a simulated semiconductor module in which the semiconductor chip element was joined to the Kovar substrate was obtained. A condition of the paste before molding by heating under pressure and a condition of molding by heating under pressure of the simulated semiconductor module in Example 1 are shown in Table 1.

**[Table 1]**

| | Condition of paste before molding by heating under pressure | | | Condition of molding by heating under pressure | | | |
|---|---|---|---|---|---|---|---|
| | Form of powder in paste | Cu:Sn compositi on ratio (by mass) in paste | Thickn ess of paste (µm) | Atmosp here | Applied pressur e (MPa) | Heatin g temper ature (°C) | Heating and pressur izing time (minute ) |
| Example 1 | Cu-core Sn-shell | 50:50 | 50 | N₂ | 10 | 300 | 5 |
| Example 2 | Cu-core Sn-shell | 40:60 | 50 | N₂ | 10 | 350 | 1 |
| Example 3 | Cu-core Sn-shell | 50:50 | 50 | N₂ | 10 | 250 | 10 |
| Example 4 | Cu-core Sn-shell | 50:50 | 30 | N₂+5% H₂ | 15 | 300 | 5 |
| Example 5 | Cu-core Sn-shell | 60:40 | 300 | N₂ | 10 | 300 | 5 |
| Example 6 | Cu-core Sn-shell | 50:50 | 20 | N₂ | 10 | 300 | 5 |
| Example 7 | Cu-core Sn-shell | 50:50 | 50 | N₂ | 2 | 280 | 2 |
| Example 8 | Cu-core Sn-shell | 50:50 | 200 | N₂ | 30 | 320 | 8 |
| Example 9 | Cu-core Sn-shell | 40:60 | 50 | N₂ | 10 | 350 | 1 |
| Example 10 | Cu-core Sn-shell | 50:50 | 50 | N₂ | 10 | 250 | 10 |
| Example 11 | Cu-core Sn-shell | 60:40 | 100 | N₂ | 1 | 300 | 5 |
| Comparat ive Example 1 | Mixed powder of Cu powder and Sn powder | 50:50 | 50 | N₂ | 10 | 300 | 5 |
| Comparat | Cu-core | 50:50 | 50 | N₂ | 0.9 | 300 | 5 |
| ive Example 2 | Sn-shell | | | | | | |
| Comparat ive Example 3 | Cu-core Sn-shell | 50:50 | 20 | N₂ | 32 | 300 | 5 |
| Comparat ive Example 4 | Cu-core Sn-shell | 50:50 | 50 | N₂ | 10 | 240 | 5 |
| Comparat ive Example 5 | Cu-core Sn-shell | 40:60 | 50 | N₂ | 10 | 370 | 5 |
| Comparat ive Example 6 | Cu-core Sn-shell | 60:40 | 100 | N₂ | 10 | 300 | 0.9 |
| Comparat ive Example 7 | Cu-core Sn-shell | 50:50 | 50 | N₂ | 10 | 300 | 11 |

### <Examples 2 to 11, and Comparative Examples 2 to 7>

Simulated semiconductor modules in Examples 2 to 11 and Comparative Examples 2 to 7 were obtained in the same manner as in Example 1 under the condition of a paste before molding by heating under pressure and the condition of molding by heating under pressure of a simulated semiconductor module shown in Table 1. In Example 4, an atmosphere for pressurizing and molding was an atmosphere of nitrogen gas containing 5% by volume of hydrogen gas.

### <Comparative Example 1>

A Sn powder having an average particle diameter of 10 µm was mixed with a Cu powder having an average particle diameter of 10 µm at a ratio of Cu: 50% by mass and Sn: 50% by mass to prepare a mixed powder. In the mixed powder, a RMA flux was mixed so that a ratio of the flux will be 13% by mass to prepare a paste. In the same manner as Example 1, a simulated semiconductor module in which the semiconductor chip element was joined to the Kovar substrate was obtained. A condition of the paste before molding by heating under pressure and a condition of molding by heating under pressure of the simulated semiconductor module in Comparative Example 1 are shown in Table 1.

### <Comparison Evaluation>

For 18 simulated semiconductor modules of Examples 1 to 11 and Comparative Examples 1 to 7, (1) the thickness of a joining layer of a semiconductor module, and (2) the composition ratio (by mass) of Cu and Sn in the joining layer were measured by the following methods. Further, (3) a thermal shock test was carried out by the following method. The results are shown in Table 2.

### (1) Thickness of joining layer of semiconductor module

The cross section of the joining layer of each of the semiconductor modules was observed at five positions by an optical microscope (Model No. VHX-1000, manufactured by KEYENCE CORPORATION) with a magnification of 150, and the average value of thickness of the joining layer was determined.

### (2) Composition ratio (by mass) of Cu and Sn in joining layer

The composition ratio (by mass) of Cu and Sn in each of the joining layers was determined by a scanning electron microscope-energy dispersive X-ray spectroscope (SEM-EDX) .

### (3) Thermal shock test

The simulated semiconductor modules each including the Kovar substrate and the semiconductor chip element that were joined through the joining layer were subjected to 2000 thermal cycles including at -40°C for 5 minutes and at 200°C for 5 minutes in a liquid phase (Fluorinert) using a thermal shock tester (TSB-51, manufactured by ESPEC Corporation). After the thermal shock test, the shear strength of each of the 18 simulated semiconductor modules was measured at room temperature in accordance with Test method for lead-free solders - Part 7: method for measuring shear strength of solder joints on chip components described in JIS Z 3198-7. Results are shown in Table 2. A shear strength of 40 MPa or more is represented by "excellent," a shear strength of 20 MPa to 40 MPa is represented by "good," a shear strength of 10 MPa to 20 MPa is represented by "fair," and a shear strength of less than 10 MPa is represented by "poor."

**[Table 2]**

| | Joining layer after molding by heating under pressure | | | Shear strength after thermal shock test of semiconductor module |
|---|---|---|---|---|
| | Thickness of joining layer (µm) | Cu:Sn composition ratio (by mass) | | |
| | | Central part | End | |
| Example 1 | 22 | 71:29 | 33:67 | Excellent |
| Example 2 | 16 | 84:16 | 22:78 | Good |
| Example 3 | 35 | 65:35 | 39:61 | Good |
| Example 4 | 8 | 49:51 | 46:54 | Fair |
| Example 5 | 221 | 85:15 | 14:86 | Fair |
| Example 6 | 9 | 75:25 | 30:70 | Fair |
| Example 7 | 43 | 60:40 | 37:63 | Fair |
| Example 8 | 154 | 78:22 | 20:80 | Good |
| Example 9 | 24 | 65:35 | 34:66 | Fair |
| Example 10 | 20 | 71:29 | 30:70 | Good |
| Example 11 | 67 | 75:25 | 27:73 | Fair |
| Comparative Example 1 | 30 | 48:52 | 30:70 | Poor |
| Comparative Example 2 | 45 | 70:30 | 27:73 | Poor |
| Comparative | 40 | 74:26 | 69:31 | Poor |
| Example 3 | | | | |
| Comparative Example 4 | 46 | 73:27 | 32:68 | Poor |
| Comparative Example 5 | 23 | 51:49 | 27:73 | Poor |
| Comparative Example 6 | 39 | 75:25 | 55:45 | Poor |
| Comparative Example 7 | 25 | 77:23 | 30:70 | Poor |

From comparison of Examples 1 to 11 and Comparative Examples 1 to 7 in Table 2, the following was found. In the joining layer configured such that the composition ratio of Sn increases from a central part of the joining layer to joining parts at ends of the electronic component, the shear strengths after the thermal shock test in Examples 1, 2, 3, 8, and 10 were 20 MPa or more. This shows that a good joining state is kept. The shear strengths after the thermal shock test in Examples 4, 5, 6, 7, 9, and 11 were 10 to 20 MPa or more. This shows that joining is kept, but the strength is comparatively low. Therefore, it is confirmed that there are preferable ranges of the thickness of the joining layer and the composition ratio of Sn.

On the other hand, in Comparative Example 1 in which the composition ratio of Sn was not much changed from the central part of the joining layer to the joining parts at the ends as compared with Examples 1 to 11, the shear strength was decreased to 10 MPa or less. The reason for this is considered that a crack caused by a stress applied to the joining layer in the thermal shock test developed because the composition ratio of Sn does not change so much and the joining layer is detached. In Comparative Examples 2 to 7 in which the composition ratio of Sn increases as compared with Comparative Example 1, the shear strength is also decreased to 10 MPa or less. The reason for this is considered that the adherence of the joining layer to the substrate and the element is insufficient due to insufficient pressure (Comparative Example 2), the substrate and the element are partially broken due to excess pressure (Comparative Example 3), the adherence is insufficient due to insufficient production of Sn liquid phase at low temperature (Comparative Example 4), a partial break is caused by excess stress distortion due to a difference in thermal expansion of members when the members are cooled from high temperature to room temperature (Comparative Example 5), production of an intermetallic compound by Sn-Cu inter-diffusion is insufficient due to insufficient heating (Comparative Example 6), and production of kirkendall voids by Sn-Cu inter-diffusion is caused by superheating (Comparative Example 7).

### INDUSTRIAL APPLICABILITY

The present invention can be used for a semiconductor module that is configured by joining an electronic component exposed to a high-temperature atmosphere to a substrate and is subjected to repetitive cooling and heating.

## Claims

1. A joining layer of a semiconductor module that is provided between an electronic component and a substrate, and is configured of a CuSn intermetallic compound,
wherein a composition ratio of Sn increases from a central part of the joining layer to joining parts at ends of the electronic component.

2. The joining layer of the semiconductor module according to claim 1, wherein a composition ratio of Sn at the central part of the joining layer is 20% by mass to 50% by mass and a composition ratio of Cu is the balance, and a composition ratio of Sn in the joining parts at the ends of the electronic component is 60% by mass to 80% by mass and a composition ratio of Cu is the balance.

3. The joining layer of the semiconductor module according to claim 1 or 2, wherein the joining layer has a thickness of 10 µm to 200 µm.

4. A semiconductor module comprising the joining layer according to any one of claims 1 to 3 that is provided between the electronic component and the substrate.

5. A method for manufacturing a semiconductor module comprising placing a paste containing a Cu-core/Sn-shell-powder between an electronic component and a substrate and heating the electronic component and/or the substrate at a temperature of 250°C to 350°C for 1 minute to 10 minutes under a pressure of 1 MPa to 30 MPa in an inert atmosphere or a reducing atmosphere while the paste is kept, to join the electronic component to the substrate.

6. The method for manufacturing the semiconductor module according to claim 5, wherein a composition ratio of Sn in the Cu-core/Sn-shell-powder is 40% by mass to 60% by mass, and a composition ratio of Cu is the balance.
